(19) **Europäisches Patentamt European Patent Office Office européen des brevets**

(11) **EP 4 501 496 A1**

(12) **EUROPEAN PATENT APPLICATION**
published in accordance with Art. 153(4) EPC

(43) Date of publication:
05.02.2025 Bulletin 2025/06

(21) Application number: 23781036.1

(22) Date of filing: 31.03.2023

(51) International Patent Classification (IPC):
$B22F\ 1/00^{(2022.01)}$    $B22F\ 1/054^{(2022.01)}$
$B22F\ 1/06^{(2022.01)}$    $B22F\ 1/07^{(2022.01)}$
$B22F\ 1/102^{(2022.01)}$    $B22F\ 1/103^{(2022.01)}$
$B22F\ 1/16^{(2022.01)}$    $B22F\ 7/08^{(2006.01)}$
$B22F\ 9/00^{(2006.01)}$    $B22F\ 9/20^{(2006.01)}$
$B82Y\ 30/00^{(2011.01)}$    $B82Y\ 40/00^{(2011.01)}$
$C22C\ 1/04^{(2023.01)}$    $C22C\ 32/00^{(2006.01)}$
$H01L\ 21/52^{(2006.01)}$

(52) Cooperative Patent Classification (CPC):
B22F 1/00; B22F 1/054; B22F 1/06; B22F 1/07;
B22F 1/102; B22F 1/103; B22F 1/16; B22F 7/08;
B22F 9/00; B22F 9/20; B82Y 30/00; B82Y 40/00;
C22C 1/04; C22C 32/00; H01L 21/52

(86) International application number:
PCT/JP2023/013465

(87) International publication number:
WO 2023/191028 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.03.2022  JP 2022061331
19.10.2022  JP 2022167371
19.10.2022  JP 2022167366

(71) Applicant: Kyocera Corporation
Kyoto-shi, Kyoto 612-8501 (JP)

(72) Inventors:
• KIKUCHI, Tomonao
Kyoto-shi, Kyoto 612-8501 (JP)
• NONOMURA, Kouki
Kyoto-shi, Kyoto 612-8501 (JP)

(74) Representative: Viering, Jentschura & Partner
mbB
Patent- und Rechtsanwälte
Am Brauhaus 8
01099 Dresden (DE)

(54) **COPPER PARTICLE AND METHOD FOR PRODUCING SAME, PASTE COMPOSITION, SEMICONDUCTOR DEVICE, ELECTRICAL COMPONENT, AND ELECTRONIC COMPONENT**

(57)    A copper particle in which a ratio $S_{Cu}\ (111)/S_{Cu}\ (220)$ of a crystallite diameter $S_{Cu}\ (111)$ at a Miller index (111) of copper to a crystallite diameter $S_{Cu}\ (220)$ at a Miller index (220) of copper in X-ray diffraction satisfies the following equation (1) or the following equation (2):

$$S_{Cu}\ (111)/S_{Cu}\ (220) > 1.4\ ...\ (1)$$

$$S_{Cu}\ (111)/S_{Cu}\ (220) < 1.2\ ...\ (2).$$

EP 4 501 496 A1

**Description**

TECHNICAL FIELD

The present disclosure relates to a copper particle, a method for producing the copper particle, a paste composition, and a semiconductor device, an electrical component, and an electronic component that are bonded by the paste composition.

BACKGROUND OF INVENTION

As semiconductor products become larger in capacity, higher in processing speed, and finer in wiring, the semiconductor products generate a large amount of heat during operation. The dissipation of heat from semiconductor products, so-called thermal management, is becoming increasingly important. For this reason, commonly employed is a method of attaching a heat dissipating member such as a heat spreader or a heat sink to a semiconductor product. The material for adhering the heat dissipating member is desired to have higher thermal conductivity.

In some cases, semiconductor elements are adhered to an organic substrate having a heat dissipation mechanism such as a thermal via. Also in this case, the material for adhering semiconductor elements is required to have high thermal conductivity. In addition, due to the recent increase in luminance of white light-emitting LEDs, materials for adhering semiconductor elements have been widely used in lighting devices such as backlight illumination, ceiling light, and downlight for full-color liquid crystal screens. With high current input due to high output of light-emitting elements, an adhesive between a light-emitting element and a substrate is discolored by heat, light, or the like, or an electrical resistance value changes with time. In particular, in the method in which the bonding between a light-emitting element and a substrate relies on an adhesive, a bonding material may peel off due to reduced adhesive strength at the solder melting temperature during the solder mounting of electronic components, resulting in non-lighting in some cases. In addition, as the performance of white light-emitting LEDs improves, the amount of heat generated by light-emitting element chips increases. Thus, the structure of LEDs and members used in LEDs are also required to have improved heat dissipation properties.

In particular, in recent years, power semiconductor devices using a wide band gap semiconductor element such as silicon carbide (SiC) or gallium nitride (GaN) having a small power loss have been actively developed. These elements have high heat resistance and can be operated at a high temperature not lower than 250°C with a large current. To exhibit such characteristics, efficient dissipation of heat generated in operation is required, and a bonding material having long-term and high-temperature heat resistance in addition to electrical conductivity and thermal conductivity is required.

As described above, a die attach paste, a material for adhering a heat dissipating member, and the like used for adhering the members of a semiconductor device, an electrical component, and an electronic component are required to have high thermal conductivity. At the same time, these materials need to be resistant to reflow treatment during mounting of the product on the substrate.

As a paste material capable of withstanding such a demand, a bonding method using silver nanoparticles has been attracting attention, which enables bonding at a temperature lower than that of bulk silver (see, for example, Patent Literature 1).

Silver particles have very high conductivity, but due to their high price and migration difficulties, replacement with other metals has been studied. Thus, copper particles that are less expensive than silver particles and have migration resistance are attracting attention. A bonding material containing copper nanoparticles and copper microparticles and/or copper submicroparticles has been proposed (for example, see Patent Literature 2).

CITATION LIST

PATENT LITERATURE

Patent Literature 1: JP 2011-240406 A
Patent Literature 2: JP 2014-167145 A

SUMMARY

That is, the present disclosure relates to the following.

[1] A copper particle in which a ratio $S_{Cu}$ (111)/$S_{Cu}$ (220) of a crystallite diameter $S_{Cu}$ (111) at a Miller index (111) of copper to a crystallite diameter $S_{Cu}$ (220) at a Miller index (220) of copper in X-ray diffraction satisfies the following equation (1) or the following equation (2):

$$S_{Cu} (111)/S_{Cu} (220) > 1.4 \ ... \ (1)$$

$$S_{Cu} (111)/S_{Cu} (220) < 1.2 \ ... \ (2).$$

[6] A method for producing the copper particle according to any one of [1] to [5], the method including reducing, in the presence of a shape stabilizer, cuprous oxide having a crystallite diameter $S_{Cu2O}$ (111) at a Miller index (111) of not less than 70 nm in X-ray diffraction.
[8] A paste composition containing the copper particle according to any one of [1] to [5].
[9] A semiconductor device formed by bonding using the paste composition according to [8].
[10] An electrical component formed by bonding using the paste composition according to [8].
[11] An electronic component formed by bonding using the paste composition according to [8].

BRIEF DESCRIPTION OF THE DRAWINGS

FIG. 1 is a cross-sectional view of a semiconductor device according to an embodiment of the present disclosure.
FIG. 2 is a cross-sectional view of an electrical component according to an embodiment of the present disclosure.
FIG. 3 is a scanning electron microscope image of a copper cake according to Example 3.
FIG. 4 is a scanning electron microscope image of a copper cake according to Example 5.
FIG. 5 is a scanning electron microscope image of a copper cake according to Comparative Example 1.

DESCRIPTION OF EMBODIMENTS

A paste using sinterable copper nanoparticles has a reliability problem in many cases because a bonding layer formed by sintering has vacancies. In particular, in the bonding of an LED or the like, a bonded body is sealed with a silicone resin having high oxygen permeability or exposed to the atmosphere in most cases, and there is a possibility that the bonding layer is oxidized during a reliability test such as a cooling and heating cycle test, resulting in reduced reliability. The present disclosure relates to a copper particle having high bonding strength and capable of obtaining a semiconductor device or the like having high denseness and high reliability by sintering, a method for producing the copper particle, a paste composition, and a semiconductor device, an electrical component, and an electronic component which are bonded by the paste composition.
Hereinafter, the present disclosure will be described in detail with reference to an embodiment.
In the present disclosure, the "non-volatile content concentration" or the "solid content concentration" of a composition means a concentration of components excluding a solvent in a total amount of the composition.
In the present description, wording of "from XX to YY" refers to "not less than XX and not more than YY". In the present description, with regard to numerical ranges (e.g., ranges such as content), lower and upper limit values described in a stepwise manner may each be independently combined. In a numerical range described herein, the upper or lower limit value of the numerical range may be replaced by a value presented in the examples.

Copper Particle

The copper particle according to the present disclosure is a copper particle in which a ratio $S_{Cu}$ (111)/$S_{Cu}$ (220) of a crystallite diameter $S_{Cu}$ (111) at a Miller index (111) of copper to a crystallite diameter $S_{Cu}$ (220) at a Miller index (220) of copper in X-ray diffraction satisfies the following equation (1) or the following equation (2):

$$S_{Cu} (111)/S_{Cu} (220) > 1.4 \ ... \ (1)$$

$$S_{Cu} (111)/S_{Cu} (220) < 1.2 \ ... \ (2).$$

The copper particle according to the present disclosure may contain a copper oxide as long as it satisfies the equation (1) or (2).
The copper particle has high bonding strength and is capable of obtaining a semiconductor device or the like having high denseness and high reliability by sintering. The reason is not clear, but is presumed as follows.
That is, when the ratio $S_{Cu}(111)/S_{Cu}(220)$ is not less than 1.2 and not more than 1.4, trade-off between sintering activity and sintering inhibition depending on a magnitude of particle diameter cannot be eliminated. When the ratio is more than 1.4 or less than 1.2, the trade-off can be eliminated and high sinterability can be obtained.

The ratio $S_{Cu}(111)/S_{Cu}(220)$ can be controlled by appropriately adjusting a reduction rate after formation of a nucleus serving as an origin of a plate-shaped particle (plate-shaped copper particle). A plurality of factors such as a temperature at the time of nucleus formation, the reduction rate, the type of a shape stabilizer, and a critical saturation concentration have an extremely complicated influence on the formation of the nucleus serving as the origin of plate-shaped particle. For example, in the case of a high nucleation temperature, a low crystallinity of cuprous oxide, or a small number of carbon atoms of a carboxylic acid constituting the shape stabilizer, it is often difficult to form the nucleus serving as the origin of the plate-shaped particle.

From this viewpoint, the equation (1) may be the following equation (1A), the following equation (1B), the following equation (1C), or the following equation (1D):

$$S_{Cu}(111)/S_{Cu}(220) \geq 1.45 \ .... \ (1A)$$

$$S_{Cu}(111)/S_{Cu}(220) \geq 1.46 \ ... \ (1B)$$

$$S_{Cu}(111)/S_{Cu}(220) \geq 1.48 \ ... \ (1C)$$

$$S_{Cu}(111)/S_{Cu}(220) \geq 1.5 \ ... \ (1D).$$

An upper limit value of the $S_{Cu}(111)/S_{Cu}(220)$ value in the above equations (1A) to (1D) is not particularly limited. From the viewpoint of ease of production and the like, the value may be not more than 10, not more than 5.0, not more than 3.0, or not more than 2.0.

From this viewpoint, the equation (2) may be the following equation (2A), the following equation (2B), the following equation (2C), or the following equation (2D):

$$S_{Cu}(111)/S_{Cu}(220) \leq 1.0 \ ... \ (2A)$$

$$S_{Cu}(111)/S_{Cu}(220) \leq 0.8 \ ... \ (2B)$$

$$S_{Cu}(111)/S_{Cu}(220) \leq 0.6 \ ... \ (2C).$$

$$S_{Cu}(111)/S_{Cu}(220) \leq 0.5 \ ... \ (2D).$$

A lower limit value of the $S_{Cu}(111)/S_{Cu}(220)$ value in the above equations (2A) to (2D) is not particularly limited. From the viewpoint of ease of production and the like, the value may be not less than 0.1, not less than 0.2, not less than 0.3, or not less than 0.4.

The crystallite diameter $S_{Cu}(111)$ may be not more than 60 nm. When the content is not more than 60 nm, high sinterability can be ensured. From this viewpoint, the crystallite diameter $S_{Cu}(111)$ may be from 5 to 60 nm, from 5 to 50 nm, from 10 to 40 nm, or from 15 to 40 nm.
The crystallite diameter $S_{Cu}(220)$ may be not more than 70 nm. When the content is not more than 70 nm, high sinterability can be ensured. In addition, the crystallite diameter $S_{Cu}(220)$ may be not less than 5 nm from the viewpoint of ensuring high sinterability. From these viewpoints, the crystallite diameter $S_{Cu}(220)$ may be from 5 to 70 nm, from 10 to 50 nm, or from 15 to 35 nm.

In the present disclosure, the crystallite diameter $S_{Cu}(111)$ is calculated with the Scherrer method using a peak at a Miller index (111) plane as determined by X-ray diffraction (XRD) measurement. Specifically, the crystallite diameter can be measured by the method described in the Examples.
In the present disclosure, the crystallite diameter $S_{Cu}(220)$ is calculated with the Scherrer method using a (220) plane peak at a Miller index as determined by X-ray diffraction (XRD) measurement. Specifically, the crystallite diameter can be measured by the method described in the Examples.

The copper particle may have a plate shape.

From the viewpoints of reduction in oxidation and denseness of a bonding layer, the copper particle may have a thickness of not less than 5 nm and not more than 50 nm, or not less than 10 nm and not more than 40 nm.

The major axis of the copper particle may be not less than 30 nm and not more than 300 nm, may be not less than 50 nm and not more than 200 nm, may be not less than 60 nm and not more than 200 nm, or not less than 70 nm and not more than 150 nm, from the viewpoints of reduction in oxidation and denseness of the bonding layer.

From the above viewpoints, the copper particle may have a thickness of from 5 to 50 nm and a diameter of from 30 to 300 nm.

The plate-shaped particle has a shape having a pair of substantially parallel planes, and a distance between the pair of planes is referred to as "thickness", and the longest diameter in the planes is referred to as "major axis".

From the above viewpoints, the copper particle may have an aspect ratio (major axis/thickness) of not less than 1.5 and not more than 10, not less than 1.8 and not more than 10, not less than 2.0 and not more than 8.0, not less than 3.0 and not more than 6.0, or not less than 4.0 and not more than 6.0.

The thickness and major axis of the copper particle are calculated as medians of length measurement values of at least 200 copper particles extracted from an image captured by a scanning electron microscope (SEM, for example, trade name: JSM-F100, available from JEOL Ltd.) under conditions of an acceleration voltage of 15 kV and 100000 times. The median of the measured values of the thicknesses of the copper particles means $\{(d_n + d_{n+1})/2\}$, when the thicknesses of n copper particles are measured, the thickness of the (n/2)th particle counted from the particle having the smallest thickness is $d_n$, and the thickness of the $\{(n/2) + 1\}$th particle counted from the particle having the smallest thickness is $d_{n+1}$.

The median of the measured values of the major axes of the copper particles means $\{(L_n + L_{n+1})/2\}$, when the major axes of n copper particles are measured, the major axis of the (n/2)th particle counted from the particle having the smallest major axis is $L_n$, and the major axis of the $\{(n/2) + 1\}$th particle counted from the particle having the smallest major axis is $L_{n+1}$. When the first decimal place of (n/2) is 5, the decimal point is rounded up, because n is an odd number.

From the viewpoints of sinterability and bondability, a mass coverage of a shell covering a surface of a core in the copper particle may be not less than 0.05%, may be not less than 0.1%, may be not less than 0.2%, or may be not less than 0.5%. An upper limit value of the mass coverage may be 10%, may be 7%, may be 5%, or may be 3%. When the mass coverage is not less than 0.05%, the particles are less likely to aggregate, and thus the fluidity of the paste is ensured. When the mass coverage is not more than 10%, the sintering inhibition can be reduced.

The copper particle according to the present disclosure may be a particle having a core made of copper and not having a shell on the surface of the core (hereinafter, sometimes referred to as single-layer particle).

In addition, the copper particle according to the present disclosure may have a core made of copper and a shell made from a shape stabilizer. The shell may be made from a shape stabilizer that is at least one of an amine or a fatty acid.

In addition, the copper particle according to the present disclosure may have a core made of copper and a shell made from a phosphoric acid derivative.

The shell of the copper particle may be made from at least one of an amine or a fatty acid and a phosphoric acid derivative, or may be made from an amine, a fatty acid, and a phosphoric acid derivative.

Single-Layer Particle or Core

Copper constituting a single-layer particle having a core made of copper and not having a shell on the surface of the core, or copper constituting a core made of copper in a copper particle having the core and the shell is derived from a copper compound. The copper compound is not particularly limited as long as the compound contains a copper atom. Examples of the copper compound include copper oxide, copper hydroxide, copper nitride, and copper carboxylate. The copper compound may be copper oxide from the viewpoint of a generation rate of the plate-shaped particle. These may be used alone or in combination of two or more.

The copper oxide may be at least one of copper (I) oxide (cuprous oxide) or copper (II) oxide, and may be copper (I) oxide from the viewpoint of productivity.

From the viewpoint of the generation rate of the plate-shaped particle, the copper oxide may have high crystallinity. In particular, from the viewpoint of the aspect ratio of the plate-shaped particle, the copper oxide may be copper (I) oxide having a crystallite diameter at a Miller index (111) of not less than 70 nm as measured by an X-ray diffraction method.

The single-layer particle or the core may be produced by reducing the cuprous oxide having a crystallite diameter $S_{Cu2O}$ (111) of not less than 70 nm in the presence of a shape stabilizer that will be described later. As a result, a generation proportion of the plate-shaped copper particle can be increased. The crystallite diameter $S_{Cu2O}$ (111) may be not less than 100 nm, not less than 400 nm, not less than 600 nm, not less than 700 nm, or not less than 800 nm. An upper limit value of the crystallite diameter $S_{Cu2O}$ (111) is not particularly limited, and may be not more than 3000 nm, not more than 2000 nm, not more than 1500 nm, not more than 1200 nm, or not more than 1000 nm.

Examples of the copper hydroxide include copper (II) hydroxide and copper (I) hydroxide.

Examples of the copper nitride include copper (II) nitride and copper (I) nitride.

Examples of the copper carboxylate include copper carboxylate anhydrides or copper carboxylate hydrates of copper (I) formate, copper (I) acetate, copper (I) propionate, copper (I) butyrate, copper (I) valerate, copper (I) caproate, copper (I) caprylate, copper (I) caprate, copper (II) formate, copper (II) acetate, copper (II) propionate, copper (II) butyrate, copper (II) valerate, copper (II) caproate, copper (II) caprylate, copper (II) caprate, copper (II) citrate, or the like. The copper carboxylate may be a copper (II) acetate monohydrate from the viewpoint of productivity and ease of availability. In addition, these may be used alone or in combination of two or more.

As the copper carboxylate, a commercially available copper carboxylate may be used, or a copper carboxylate produced by synthesis may be used.

The copper carboxylate may be synthesized by a known method, for example, by mixing and/or heating copper (II) hydroxide and a carboxylic acid compound.

The copper particle is covered with an amine and/or a carboxylic acid. These components constitute the shape stabilizer, and cover the copper particle in a generation process of the copper particle.

Shell

The shell in the copper particle having the core and the shell may be made from a shape stabilizer. Thus, sintering uniformity at the time of sintering can be obtained by improving independence of particles.

The shape stabilizer may be at least one selected from the group consisting of an amine compound, a carboxylic acid, and a neutralized salt of an amine compound and a carboxylic acid.

The shell may be made from a phosphoric acid ester.

The shell may be made from at least one selected from the shape stabilizer and the phosphoric acid ester, or may be made from the shape stabilizer and the phosphoric acid ester.

Amine Compound

Examples of the amine compound used in the present disclosure include a monoamine having one amino group and a diamine having two amino groups. Examples of the monoamine include dipropylamine, butylamine, dibutylamine, hexylamine, cyclohexylamine, heptylamine, octylamine, nonylamine, decylamine, 3-aminopropyltriethoxysilane, dodecylamine, oleylamine, monoethanolamine, 2-aminoethoxy-2-ethanol, 3-amino-1-propanol, and 3-amino-2-propanol. Examples of the diamine include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-diaminopropane, N,N'-dimethyl-1,3-diaminopropane, N,N-diethyl-1,3-diaminopropane, 1,4-diaminobutane, 1,5-diamino-2-methylpentane, 1,6-diaminohexane, N,N'-dimethyl-1,6-diaminohexane, 1,7-diaminoheptane, and 1,8-diaminooctane. Among them, an alkanolamine may be used, and an alkanolamine having 4 or more carbon atoms may be used, from the viewpoint of the generation proportion of the copper particle.

Carboxylic Acid

For the carboxylic acid of the present disclosure, examples of the monocarboxylic acid include formic acid, acetic acid, propionic acid, butyric acid, valeric acid, caproic acid, caprylic acid (octanoic acid), octylic acid, nonanoic acid, capric acid (decanoic acid), oleic acid, stearic acid, and isostearic acid. Examples of the dicarboxylic acid include oxalic acid, malonic acid, succinic acid, glutaric acid, adipic acid, pimelic acid, suberic acid, azelaic acid, sebacic acid, and diglycolic acid.

Examples of the aromatic carboxylic acid include benzoic acid, phthalic acid, isophthalic acid, terephthalic acid, salicylic acid, and gallic acid.

Examples of the hydroxy acid include glycolic acid, lactic acid, tartronic acid, malic acid, glyceric acid, hydroxybutyric acid, tartaric acid, citric acid, and isocitric acid.

Among them, from the viewpoint of the generation proportion of the copper particle, a monocarboxylic acid may be used, and a monocarboxylic acid having 6 or more carbon atoms may be used. When the monocarboxylic acid having 6 or more carbon atoms is used, stabilization of copper atoms generated by reduction is enhanced, and thus a generation rate of seed crystals and a rate of particle growth can be reduced, and copper particles having the equation (1) or the equation (2) tend to be obtained.

The number of carbon atoms of the monocarboxylic acid may be not less than 7 or not less than 8. The number of carbon atoms of the monocarboxylic acid may be not more than 20, not more than 16, or not more than 12. The monocarboxylic acid may be decanoic acid or octanoic acid.

Examples of the neutralized salt of the amine compound and the carboxylic acid used in the present disclosure include neutralized salts of the amine compounds and the carboxylic acids.

For example, a neutralized salt of an alkanolamine having 4 or more carbon atoms and a fatty acid having 6 or more carbon atoms.

Phosphoric Acid Ester

The copper particle may be covered with a phosphoric acid ester. Since a phosphoric acid ester has an action of removing the oxide film on the surface of the copper particle generated because of atmospheric exposure during heating, the copper particle has enhanced sinterability. In addition, by virtue of a lubricating effect of the copper particle when a paste composition is formed, volume shrinkage accompanying solvent volatilization during curing is made uniform, and a dense bonding layer can be formed.

The phosphoric acid ester may have an acid value and an amine value each being not more than 130 mgKOH/g, not more than 120 mgKOH/g, or not more than 110 mgKOH/g. When each of the acid value and the amine value of the phosphoric acid ester is not more than the above-described values, a change in the oxidation degree of the copper particle can be minimized. Here, the acid value (mgKOH/g) can be calculated in accordance with JIS K 0070:1992, and the amine value can be calculated in accordance with JIS K 7237:1995.

The phosphoric acid ester may have a ratio of the acid value to the amine value [acid value/amine value] that is not less than 0 and not more than 1.5, or not less than 0 and not more than 1.2. Having the ratio [acid value/amine value] within the above range can reduce a change in the oxidation degree of the copper particle.

Examples of the phosphoric acid ester include alkyl phosphates, polyoxyethylene alkyl ether phosphates, and polyoxyethylene alkyl phenyl ether phosphates. More specific examples of the phosphoric acid ester include DISPERBYK (registered trademark; hereinafter, description is omitted)-102 (acid value: 101 mgKOH/g), DISPERBYK-111 (acid value: 129 mgKOH/g), DISPERBYK-145 (acid value: 76 mgKOH/g, amine value: 71 mgKOH/g), DISPERBYK-180 (acid value: 94 mgKOH/g, amine value: 94 mgKOH/g), DISPERBYK-185 (amine value: 17 mgKOH/g), DISPERBYK-190 (acid value: 10 mgKOH/g), and DISPERBYK-2155 (amine value: 48 mgKOH/g).

The copper particle may have an oxidation degree not less than 0.01% and not more than 5.0%, not less than 0.02% and not more than 2.6%, not less than 0.05% and not more than 2.5%, and not less than 0.1% and not more than 2.0%. When the oxidation degree is not less than 0.01%, oxidation due to exposure to the air is unlikely to occur, and sintering is stable. When the oxidation degree is not more than 3.0%, sinterability improves.
The oxidation degree may be determined, for example, by analyzing data collected using an X-ray diffractometer with the Rietveld method.

Method for Producing Copper Particle

Examples of a method for producing the copper particle include a method including reducing a copper compound with a reducing compound in the presence of a shape stabilizer.

As the copper compound and the shape stabilizer, those described in the Copper Particle section above can be used.

The reducing compound is subjected to no particular limitation as long as the reducing compound has a reducing power to reduce the copper compound and release metallic copper. Examples of the reducing compound include a hydrazine derivative. Examples of the hydrazine derivative include hydrazine monohydrate, methylhydrazine, ethylhydrazine, n-propylhydrazine, i-propylhydrazine, n-butylhydrazine, i-butylhydrazine, sec-butylhydrazine, t-butylhydrazine, n-pentylhydrazine, i-pentylhydrazine, neo-pentylhydrazine, t-pentylhydrazine, n-hexylhydrazine, i-hexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine. These may be used alone or in combination of two or more.

The copper compound, the shape stabilizer, and the reducing compound may be mixed in an organic solvent.

The organic solvent may be any organic solvent as long as it exhibits properties of a complex or the like generated from a mixture obtained by mixing the raw materials described above. Any solvent that can be used as the reaction solvent can be used without particular limitation. The organic solvent may be, in particular, an alcohol exhibiting compatibility with the reducing compound.

Examples of the alcohol include 1-propanol, 2-propanol, butanol, pentanol, hexanol, heptanol, octanol, ethylene glycol, 1,3-propanediol, 1,2-propanediol, butyl carbitol, butyl carbitol acetate, ethyl carbitol, ethyl carbitol acetate, diethylene glycol diethyl ether, and butyl cellosolve. These may be used alone or in combination of two or more.

In the mixing, as for amounts of the copper compound, the shape stabilizer, and the reducing compound used, an amount of the shape stabilizer may be not less than 0.5 mol and not more than 10 mol, and an amount of the reducing compound may be not less than 0.5 mol and not more than 5 mol; or an amount of the shape stabilizer may be not less than 1 mol and not more than 6 mol, and an amount of the reducing compound may be not less than 0.8 mol and not more than 3 mol, with respect to 1 mol of the copper compound.

When both an amine compound and a carboxylic acid are used as the shape stabilizer, an amount of the carboxylic acid used may be from 0.1 to 10 mol, from 0.5 to 10 mol, from 1 to 5 mol, or from 1.5 to 3 mol, with respect to 1 mol of the amine compound.

Any amount of the organic solvent may be adopted as long as the components can sufficiently react with each other. For example, the organic solvent may be used in an approximate amount not less than 10 volumes and not more than 1000 volumes with respect to 100 volumes of the at least one type of compound selected from the shape stabilizers.

Next, the mixture is sufficiently heated to cause the reduction reaction of the copper compound to proceed. This heating can eliminate the unreacted copper compound and can satisfactorily deposit and grow metallic copper to form copper particles.

A heating temperature of the mixture may be not lower than -20°C and not higher than 140°C, may be not lower than 25°C and not higher than 120°C, or may be not lower than 40°C and not higher than 100°C. A heating time may be not less than 20 minutes and not more than 360 minutes, may be not less than 30 minutes and not more than 300 minutes, or may be not less than 40 minutes and not more than 240 minutes. When the heating temperature and the heating time are within the above ranges, the oxidation degree of the resulting copper particle can be easily controlled within the above-described range.

The heating may be performed after the reducing compound is mixed. Thus, a critical saturation state can be established at a relatively low temperature, an amount of by-product granular seed crystals which are likely to be generated at a high temperature can be reduced, plate-shaped seed crystals can be selectively generated, and a copper particle satisfying the above-described equation (1) or equation (2) is likely to be obtained.

The mixture is desirably heated at an arbitrary temperature raising rate, whereby the generation proportion of the plate-shaped particle can be increased. For example, when a reaction starting temperature is 25°C and the temperature is raised to 100°C at a temperature raising rate of 5°C/min, the reaction for generating the plate-shaped particle can be allowed to proceed.

The mixture is desirably heated by arbitrary stepwise temperature raising, whereby the generation proportion of the plate-shaped particle can be increased. For example, the reaction for generating the plate-shaped particle can be allowed to proceed through stepwise temperature raising at 25°C for 10 minutes, at 40°C for 60 minutes, at 80°C for 10 minutes, and at 100°C for 180 minutes.

Desirably, a solid precipitated with the heating is separated from excess amine compound (a) and/or carboxylic acid amine salt (b) by centrifugation or the like, then washed with an organic solvent, and centrifuged, and a copper cake is obtained. The copper particle (copper cake) may be obtained through such an operation.

The organic solvent for washing may be an alcohol. Examples of the alcohol include ethanol, 1-propanol, 2-propanol, butanol, pentanol, hexanol, heptanol, octanol, ethylene glycol, diethylene glycol, 1,3-propanediol, 1,2-propanediol, butyl carbitol, butyl carbitol acetate, ethyl carbitol, ethyl carbitol acetate, diethylene glycol diethyl ether, and butyl cellosolve. For example, the alcohol may be ethanol or diethylene glycol. These may be used alone or in combination of two or more.

The copper cake may contain a copper particle and the organic solvent.

When the copper cake contains an organic solvent, a content of the copper particle (solid content) in the copper cake may be from 50 to 95 mass%, from 65 to 90 mass%, or from 75 to 85 mass%.

The content of the copper particle and a content of the organic solvent in the copper cake can be determined by heating weight reduction measurement.

The washing may be appropriately adjusted by a number of times of washing, an amount of the organic solvent to be used, a washing time, and the like.

The number of times of washing may be, for example, not less than 2 and not more than 20, may be not less than 3 and not more than 16, may be not less than 4 and not more than 12, or may be not less than 5 and not more than 10.

The amount of the organic solvent to be used may be not less than 10 vol%, may be not less than 100 vol%, or may be not less than 1000 vol% in a volume ratio with respect to the copper particle, for example.

The washing time may be not less than 1 minute and not more than 40 minutes, may be not less than 3 minutes and not more than 35 minutes, or may be not less than 5 minutes and not more than 30 minutes.

Paste Composition

The paste composition according to the present disclosure contains the copper particle.

A content of the copper particle may be not less than 10 mass% and not more than 95 mass%, may be not less than 20 mass% and not more than 90 mass%, or may be not less than 30 mass% and not more than 85 mass% with respect to a total amount of the paste composition.

A phosphoric acid ester may be separately added to the paste composition of the present disclosure. Examples of the phosphoric acid ester include those listed above.

An amount of the phosphoric acid ester to be added may be not less than 0.01 mass% and not more than 2.0 mass%, not less than 0.1 mass% and not more than 1.8 mass%, or not less than 0.5 mass% and not more than 1.5 mass%, with respect to the total amount of the paste composition.

The paste composition of the present disclosure may contain an organic solvent. The organic solvent may be an alcohol, and examples thereof include aliphatic alcohols such as aliphatic monohydric alcohols and aliphatic polyhydric alcohols. Examples of the aliphatic monohydric alcohol include propanol. Examples of the aliphatic polyhydric alcohol include glycols, such as ethylene glycol, diethylene glycol, propylene glycol, dipropylene glycol, 1,4-butanediol, 3-methyl-1,5-pentanediol, glycerin, and polyethylene glycol. These organic solvents may be used alone or in combination of two or more.

When the paste composition of the present disclosure contains an organic solvent, the content thereof may be not less than 10 parts by mass and not more than 50 parts by mass, or may be not less than 20 parts by mass and not more than 40 parts by mass based on 100 parts by mass of the copper particle. Having the content not less than 10 parts by mass, with which the viscosity does not become too high, can improve workability. Having the content not more than 50 parts by mass can reduce the viscosity reduction, reduce settling of the copper in the paste composition, and improve reliability.

In the paste composition of the present disclosure, in addition to the above components, a thermosetting resin, a curing accelerator, a stress reducing agent such as rubber and silicone, a coupling agent, an antifoaming agent, a surfactant, a colorant such as a pigment and a dye, a polymerization inhibitor, an antioxidant, and other various additives that are commonly blended in this type of composition can be blended as necessary. Each of these additives may be used alone, or two or more may be mixed and used.

Method for Producing Paste Composition

The paste composition of the present disclosure may be prepared by sufficiently mixing the copper particle described above and, as necessary, additives such as the second copper particles, a phosphoric acid ester, an organic solvent, a thermosetting resin, a coupling agent, and the like, then further performing a kneading treatment with a disperser, a kneader, a three-roll mill, or the like, and then defoaming the resulting mixture.

The viscosity of the paste composition of the present disclosure may be not less than 20 Pa·s and not more than 300 Pa·s or may be not less than 40 Pa·s and not more than 200 Pa·s.
A bonding strength of the paste composition of the present disclosure may be not less than 25 MPa or may be not less than 30 MPa.
The viscosity and the bonding strength may be measured by the methods described in Examples.

The paste composition of the present disclosure thus produced has good storage stability and oxidation resistance and can maintain high sinterability and bondability without being affected by the atmospheric exposure time before curing.

Using the paste composition of the present disclosure makes a bonded body having good connection reliability with respect to a temperature cycle. It can be seen that the connection reliability with respect to the temperature cycle is good even when sealing with an epoxy sealing material or the like is not performed.

Semiconductor Device, Electrical Component, and Electronic Component

Since a semiconductor device, an electrical component, and an electronic component of the present disclosure are bonded by using the paste composition described above, their reliability is high.

The semiconductor device of the present disclosure is formed by bonding a semiconductor element on a substrate serving as an element support member using the paste composition described above. That is, here, the paste composition is used as a die attach paste, and the semiconductor element and the substrate are bonded and fixed to each other via the paste.

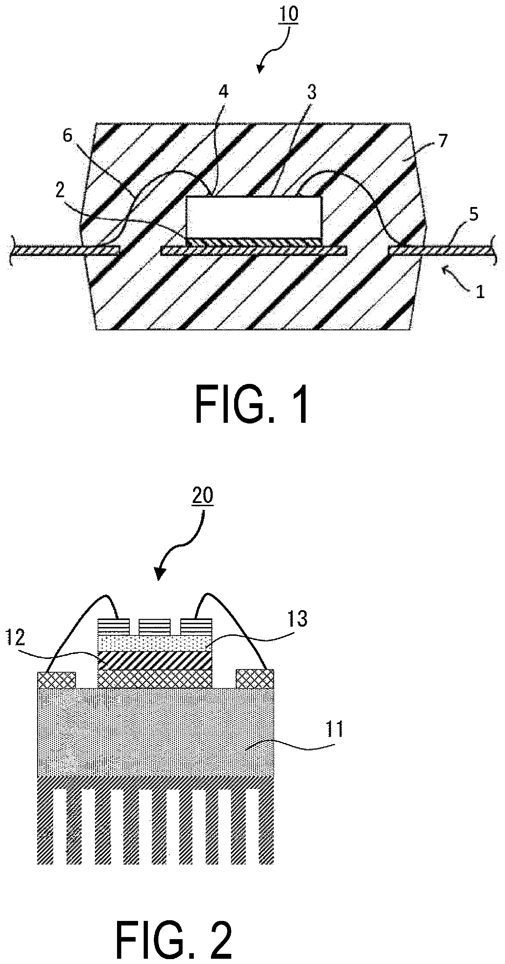

FIG. 1 is a cross-sectional view of the semiconductor device according to the present disclosure. A semiconductor device 10 is provided with a semiconductor element 3 on a lead frame 1 with a cured product 2 of a paste composition interposed between the semiconductor element and the lead frame. A bonding wire 6 connects an electrode 4 on the semiconductor element 3 and a lead 5 of the lead frame 1, and a cured product 7 of a sealing resin composition seals these members.

Here, the semiconductor element may be any known semiconductor element, and examples thereof include transistors and diodes. Examples of the semiconductor element further include wide bandgap semiconductor elements such as SiC and GaN; and light-emitting elements such as LEDs. The type of the light-emitting element is not particularly limited. Examples of the light-emitting element also include those in which a nitride semiconductor, such as InN, AlN, GaN, InGaN, AlGaN, or InGaAlN, is formed as a light-emitting layer on a substrate by an MOBVC method or the like. Examples of the element support member include a support member made of a material such as copper, silver-plated copper, a pre-plating lead frame (PPF), glass epoxy, or ceramics.

Using the paste composition of the present disclosure makes a semiconductor device have good connection reliability with respect to a temperature cycle after mounting. Since the oxidation of the copper particles is small and the sinterability is stable, the semiconductor device also has an advantage of small temporal change in output and long life with long-time driving.

The electrical component and the electronic component of the present disclosure are formed by bonding a heat dissipating member to a heat generating member using the paste composition. That is, the paste composition is used as a material for bonding heat dissipating members, and the heat dissipating member and the heat generating member are bonded and fixed to each other via the paste composition.

FIG. 2 is a cross-sectional view of the electrical component according to the present disclosure. An electrical component 20 is provided with a heat generating member 13 on a heat dissipating member 11 with a cured product 12 of a paste composition interposed between the heat generating member and the heat dissipating member.

The heat generating member may be the semiconductor element or a member having the semiconductor element, or may be another heat generating member. Examples of the heat generating member other than the semiconductor element include optical pickups and power transistors. In addition, examples of the heat dissipating member include heat sinks and heat spreaders.

Bonding the heat dissipating member to the heat generating member in this manner using the paste composition can efficiently release the heat generated in the heat generating member to the outside with the heat dissipating member and can reduce the temperature rise of the heat generating member. The heat generating member and the heat dissipating member may be directly bonded to each other with the paste composition, or may be indirectly bonded to each other with another member having high thermal conductivity interposed therebetween.

EXAMPLES

The present disclosure will be specifically described through examples; however, the present disclosure is not limited in any way to these examples.

Production of Copper Particle

Example 1

10 mmol of Cuprous oxide (trade name: FRC-10A, available from Furukawa Chemicals Co., Ltd., crystallite diameter $S_{Cu2O}$ (111) at a Miller index (111): 625 nm) as a copper compound, 20 mmol of dodecylamine (Farmin 20D, available from Kao Corporation), 40 mmol of decanoic acid (capric acid, available from New Japan Chemical Co., Ltd.), 10 mmol of hydrazine monohydrate (trade name: Hydrazine Monohydrate, available from FUJIFILM Wako Pure Chemical Corporation), and 10 mL of 1-propanol (1-propanol, available from Tokyo Chemical Industry Co., Ltd.) as an organic solvent were charged into a 50 mL sample bottle, and mixed in an aluminum block type heating stirrer at 25°C for 15 minutes. Thereafter, the set temperature was changed to 100°C, and mixing was performed for 180 minutes. The obtained reaction solution was centrifuged under the conditions: at 10000 rpm and 25°C for 15 minutes, and the supernatant liquid was discarded. Ethanol (trade name: Ethanol, available from Tokyo Chemical Industry Co., Ltd.) was added as a washing solution, and the mixture was stirred with a vacuum planetary centrifugal mixer under the conditions: at 10000 rpm and 25°C for 10 minutes, and then centrifuged under the conditions: at 10000 rpm and 25°C for 15 minutes, and the supernatant liquid was discarded. This operation was repeated four times. Further, the same operation was repeated twice except that ethanol was changed to diethylene glycol (available from Tokyo Chemical Industry Co., Ltd.), whereby a copper cake (solid) was produced.

The obtained copper cake was analyzed as described below. As a result, the copper cake was a copper particle having a thickness of 31 nm, a major axis of 60 nm, a crystallite diameter $S_{Cu}$ (220) at a Miller index (220) of copper of 38 nm, and a crystallite diameter $S_{Cu}$ (111) at a Miller index (111) of copper of 55 nm.

Example 2

A copper cake was produced by the same operation as in Example 1 except that aminoethoxyethanol (trade name: 2-Aminoethoxy-2-Ethanol, available from Tokyo Chemical Industry Co., Ltd.) was used as the amine.

Example 3

A copper cake was produced by the same operation as in Example 2 except that cuprous oxide (trade name: FRC-D30, available from Furukawa Chemicals Co., Ltd., crystallite diameter $S_{Cu2O}$ (111) at a Miller index (111): 878 nm) was used as the copper compound.

Example 4

A copper cake was produced by the same operation as in Example 3 except that octanoic acid (trade name: Lunac 8-98, available from Kao Corporation) was used as the carboxylic acid.

Example 5

A copper cake was produced by the same operation as in Example 4 except that an ethanol solution of 0.5 mass% of a phosphoric acid ester (trade name: DISPERBYK145, available from BYK Japan KK) was used as the washing solvent, and that a copper particle covered with a phosphoric acid ester was produced.

Comparative Example 1

10 mmol of Cuprous oxide (trade name: R, available from Furukawa Chemicals Co., Ltd., crystallite diameter $S_{Cu2O}$ (111) at a Miller index (111): 657 nm) as a copper compound, 20 mmol of dodecylamine (Farmin 20D, available from Kao Corporation), 40 mmol of octanoic acid (trade name: Lunac 8-98, available from Kao Corporation), and 10 mL of 1-propanol (1-propanol, available from Tokyo Chemical Industry Co., Ltd.) as an organic solvent were charged into a 50 mL sample bottle, and the temperature was raised to 100°C in an aluminum block type heating stirrer. Thereafter, 10 mmol of hydrazine monohydrate (trade name: Hydrazine Monohydrate, available from FUJIFILM Wako Pure Chemical Corporation) was added, and mixing was performed at 100°C for 180 minutes. The obtained reaction solution was centrifuged under the conditions: at 10000 rpm and 25°C for 15 minutes, and the supernatant liquid was discarded. Ethanol (trade name: Ethanol, available from Tokyo Chemical Industry Co., Ltd.) was added as a washing solvent, and the mixture was stirred with a vacuum planetary centrifugal mixer under the conditions: at 10000 rpm and 25°C for 10 minutes, and then centrifuged under the conditions: at 10000 rpm and 25°C for 15 minutes, and the supernatant liquid was discarded. This operation was repeated four times. Further, the same operation was repeated twice except that ethanol was changed to diethylene glycol (available from Tokyo Chemical Industry Co., Ltd.), whereby a copper cake (solid) was produced.

Comparative Example 2

A copper cake was produced by the same operation as in Example 2 except that acetic acid (trade name: Acetic Acid, available from FUJIFILM Wako Pure Chemical Corporation) was used as the carboxylic acid, and that cuprous oxide (trade name: R, available from Furukawa Chemicals Co., Ltd., crystallite diameter $S_{Cu2O}$ (111) at a Miller index (111): 657 nm) was used as the copper compound.

Evaluation Method

Method for Evaluating Copper Particle

Crystallite Diameter and the Like

The copper cake produced in each of the Examples and the Comparative Examples was applied onto a glass to a thickness of 200 μm, and the crystallite diameter $S_{Cu}$ (220) and the crystallite diameter $S_{Cu}$ (111) were calculated from the Scherrer equation with respect to Miller index (111) and (220) plane peaks by a concentration method using a CuKα ray as a radiation source with an X-ray diffractometer (product name: SmartLab SE, available from Rigaku Corporation). The crystallite diameter ratio was obtained by dividing the value of the crystallite diameter $S_{Cu}$ (111) by the value of the crystallite diameter $S_{Cu}$ (220). The results are listed in Table 1.
Note that a split pseudo-Voigt function was used as the fitting function, FWHD was used as the width, and 0.94 was used as the Scherrer constant.

Thickness and Major Axis

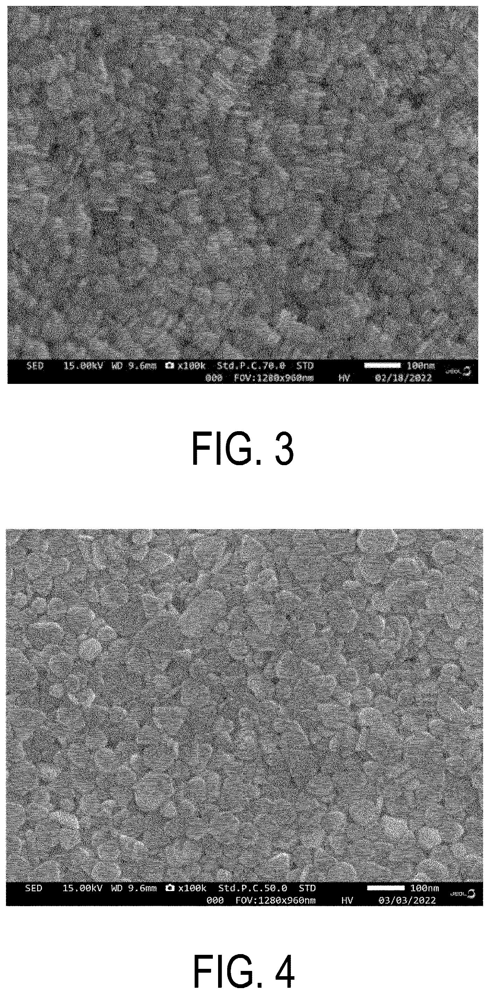

Each of the copper cake produced in each of the Examples and the Comparative Examples was applied to a brass-made sample table to which a carbon tape was attached, and dried under the conditions: at 90°C for 3 hours in a nitrogen atmosphere to obtain a copper particle. Thereafter, the thickness and major axis of the copper particle were calculated as medians of length measurement values of at least 200 copper particles extracted from an image captured by a scanning electron microscope (SEM, trade name: JSM-F100, available from JEOL Ltd.) under conditions of an acceleration voltage of 15 kV and 100000 times. FIGs. 3 to 5 are scanning electron microscope images of the copper cakes according to Example 3, Example 5, and Comparative Example 1, respectively.

The median of the measured values of the thicknesses of the copper particles means $\{(d_n + d_{n+1})/2\}$, when the thicknesses of n copper particles are measured, the thickness of the (n/2)th particle counted from the particle having the smallest thickness is $d_n$, and the thickness of the $\{(n/2) + 1\}$th particle counted from the particle having the smallest thickness is $d_{n+1}$. Similarly, the median of the measured values of the major axes of the copper particles means $\{(L_n + L_{n+1})/2\}$, when the major axes of n copper particles are measured, the major axis of the (n/2)th particle counted from the particle having the smallest major axis is $L_n$, and the major axis of the $\{(n/2) + 1\}$th particle counted from the particle having the smallest major axis is $L_{n+1}$.

When the first decimal place of (n/2) is 5, the decimal point is rounded up, because n is an odd number.

Coverage

The solid before the washing operation with diethylene glycol in each of the Examples and the Comparative Examples was collected, the temperature was raised from 30°C to 450°C at a rate of 20°C/min using a thermogravimeter (trade name: STA7200RV, available from Hitachi High-Tech Corporation), and the reduction rate between the weights at 150°C and 450°C was calculated and defined as the coverage.

Oxidation Degree

The copper cake produced in each of the Examples and the Comparative Examples was applied onto a glass to a thickness of 200 μm, and the cuprous oxide content rate was calculated by a reference intensity ratio method based on a ratio between peak areas at a Miller index (111) of copper and at a Miller index (111) of cuprous oxide by a concentration method using a CuKα ray as a radiation source with an X-ray diffractometer (product name: SmartLab SE, available from Rigaku Corporation), and defined as the oxidation degree. Note that the split pseudo-Voigt function was used as the fitting function.

Viscosity

The viscosity at 0.5 rpm of the copper paste obtained in each of the Examples and the Comparative Examples was measured using a cone-plate viscosimeter (product name: DVNXHBCBG, available from Brookfield Engineering Laboratories, Inc.), and a viscosity value was obtained. Note that CPA 51Z was used as the cone plate.

Method for Evaluating Reliability Test

Test Piece with Sealing Resin

The copper cake produced in each of the Examples and the Comparative Examples was diluted with diethylene glycol to a non-volatile content concentration of 80 mass%, whereby a copper paste was produced.

A silicon chip (surface-treated with Ti-Au) of 3 mm × 3 mm × 200 μm was bonded to a v-QFP frame (surface-treated with Ni-Pd-Au, a die pad of 4 mm × 4 mm) using the copper paste, and sintered at 200°C for 60 minutes in a nitrogen (3 vol% hydrogen) atmosphere. Thereafter, mold curing was performed with a sealing resin (trade name: KE-G3000D, available from KYOCERA Corporation).

Test Piece Without Sealing Resin

The copper cake produced in each of the Examples and the Comparative Examples was diluted with diethylene glycol to a non-volatile content concentration of 80 mass%, whereby a copper paste (paste composition) was produced.

An AIN piece (surface-treated with Ti-Pd-Au) of 3 mm × 3 mm × 200 μm was bonded to a copper plate (surface-treated with Ni-Pd-Au) using the copper paste, and sintered at 200°C for 60 minutes in a nitrogen (3 vol% hydrogen) atmosphere.

Bonding Strength

For the test piece without the sealing resin, the die shear strength at room temperature (25°C) was measured using a DAGE 4000Plus (product name, available from Nordson K.K.). The results are listed in Table 1.

Denseness

The test piece without the sealing resin was embedded in an epoxy resin, then subjected to cross section processing, and observed by FE-SEM (trade name: JSM-F100. available from JEOL Ltd.), and the area ratio of the copper layer was calculated from the binarized image of the end of the bonding layer. The results are listed in Table 1.

Reliability test (cooling and heating cycle test)

The test piece without the sealing resin and the test piece with the sealing resin were subjected to a cooling and heating cycle test. As the test conditions, one cycle was from -40°C/30 minutes to 120°C/30 minutes, and 2000 cycles were performed. The rate of change in thermal resistance of the bonded portion, which was obtained from a transient thermal resistance measuring device (product name: T3Ster, available from Siemens K.K.), before and after the cooling and heating cycle test was calculated. The results are listed in Table 1. The "abnormal" means that the rate of change exceeds 10%.

[Table 1]

Table 1

| | | Unit | Example 1 | Example 2 | Example 3 | Example 4 | Example 5 | Comparative Example 1 | Comparative Example 2 |
|---|---|---|---|---|---|---|---|---|---|
| Component | Copper compound | Cuprous oxide (FRC-10A) | mmol | 10 | 10 | | | | | |
| | | Cuprous oxide (FRC-D30) | mmol | | | 10 | 10 | 10 | | |
| | | Cuprous oxide (R) | mmol | | | | | | 10 | 10 |
| | Amine | Dodecylamine | mmol | 20 | | | | | 20 | 20 |
| | | Aminoethoxyethanol | mmol | | 20 | 20 | 20 | 20 | | |
| | Carboxylic acid | Decanoic acid | mmol | 40 | 40 | 40 | | | | |
| | | Octanoic acid | mmol | | | | 40 | 40 | 40 | |
| | | Acetic acid | mmol | | | | | | | 40 |
| | Reducing compound | Hydrazine monohydrate | mmol | 10 | 10 | 10 | 10 | 10 | 10 | 10 |
| | Organic solvent | 1-Propanol | mL | 10 | 10 | 10 | 10 | 10 | 10 | 10 |
| | Washing solvent | Type | - | Ethanol + diethylene glycol | Ethanol + diethylene glycol | Ethanol + diethylene glycol | Ethanol + diethylene glycol | Ethanol solution of 0.5 mass% of phosphoric acid ester + diethylene glycol | Ethanol + diethylene glycol | Ethanol + diethylene glycol |
| | Stirring | Temperature | °C | 25 | 25 | 25 | 25 | 25 | - | 25 |
| | | Time | min | 15 | 15 | 15 | 15 | 15 | - | 15 |
| | Mixing | Temperature | °C | 100 | 100 | 100 | 100 | 100 | 100 | 100 |
| | | Time | min | 180 | 180 | 180 | 180 | 180 | 180 | 180 |

| | | | Unit | Example 1 | Example 2 | Example 3 | Example 4 | Example 5 | Comparative Example 1 | Comparative Example 2 |
|---|---|---|---|---|---|---|---|---|---|---|
| Manufacturing conditions | Centrifugation | Rotation speed | rpm | 10,000 | 10,000 | 10,000 | 10,000 | 10,000 | 10,000 | 10,000 |
| | | Temperature | °C | 25 | 25 | 25 | 25 | 25 | 25 | 25 |
| | | Time | min | 15 | 15 | 15 | 15 | 15 | 15 | 15 |
| | Washing | Rotation speed | rpm | 10,000 | 10,000 | 10,000 | 10,000 | 10,000 | 10,000 | 10,000 |
| | | Temperature | °C | 25 | 25 | 25 | 25 | 25 | 25 | 25 |
| | | Time | min | 10 | 10 | 10 | 10 | 10 | 10 | 10 |
| | Centrifugation | Rotation speed | rpm | 10,000 | 10,000 | 10,000 | 10,000 | 10,000 | 10,000 | 10,000 |
| | | Temperature | °C | 25 | 25 | 25 | 25 | 25 | 25 | 25 |
| | | Time | min | 15 | 15 | 15 | 15 | 15 | 15 | 15 |
| Evaluation | Copper particle | $S_{Cu}$ (111) | nm | 55 | 25 | 15 | 38 | 38 | 32 | 48 |
| | | $S_{Cu}$ (220) | nm | 38 | 41 | 36 | 25 | 25 | 25 | 36 |
| | | $S_{Cu}$ (111)/$S_{Cu}$ (220) | - | 1.45 | 0.61 | 0.42 | 1.52 | 1.52 | 1.28 | 1.33 |
| | | Thickness | nm | 31 | 24 | 15 | 25 | 25 | 70 | 115 |
| | | Major axis | | 60 | 55 | 75 | 120 | 120 | 70 | 115 |
| | | Aspect ratio (major axis/thickness) | - | 1.9355 | 2.2917 | 5 | 4.8 | 4.8 | 1 | 1 |
| | | Coverage | % | 5 | 5 | 2 | 1 | 2 | 2 | 1 |
| | | Oxidation degree | % | 2 | 1 | Less than 1 | Less than 1 | Less than 1 | 1 | Less than 1 |
| | Viscosity | | Pa·s | 190 | 220 | 120 | 90 | 60 | 200 | 130 |
| | Bonding strength | | MPa | 42 | 55 | 68 | 72 | 81 | 15 | 4 |
| | Denseness (area ratio of copper layer) | | % | 82 | 85 | 87 | 89 | 91 | 72 | 61 |
| | Test piece with sealing resin | Cooling and heating cycle test | % | 2 | 0 | 0 | 0 | 0 | 120 | 160 |

(continued)

| | | | Unit | Example 1 | Example 2 | Example 3 | Example 4 | Example 5 | Comparative Example 1 | Comparative Example 2 |
|---|---|---|---|---|---|---|---|---|---|---|
| | Test piece without sealing resin | Cooling and heating cycle test | % | 7 | 5 | 0 | 0 | 0 | 180 | 320 |

16

The copper particles of Examples 1 to 5 had a ratio $S_{Cu}$ (111)/$S_{Cu}$ (220) of more than 1.4 or less than 1.2, and thus had excellent bonding strength, high denseness, and high reliability.

On the other hand, in the case of the copper particle of Comparative Example 1, stirring at 25°C for 15 minutes was not performed at the beginning, and thus the critical saturation state could not be established at a relatively low temperature, the amount of by-product granular seed crystals which are likely to be generated at a high temperature increased, and plate-shaped seed crystals could not be selectively generated. For this reason, the ratio $S_{Cu}$ (111)/$S_{Cu}$ (220) was in a range of from 1.2 to 1.4. Therefore, the copper particle was inferior to those of Examples 1 to 5 in all of bonding strength, denseness, and reliability.

In addition, the copper particle of Comparative Example 2 contained a monocarboxylic acid having less than 6 carbon atoms, and thus the copper atoms generated by reduction could not be strongly stabilized, and the generation rate of seed crystals and rate of particle growth could not be reduced. For this reason, the ratio $S_{Cu}$ (111)/$S_{Cu}$ (220) was in the range of from 1.2 to 1.4. Therefore, the copper particle was inferior to those of Examples 1 to 5 in all of bonding strength, denseness, and reliability.

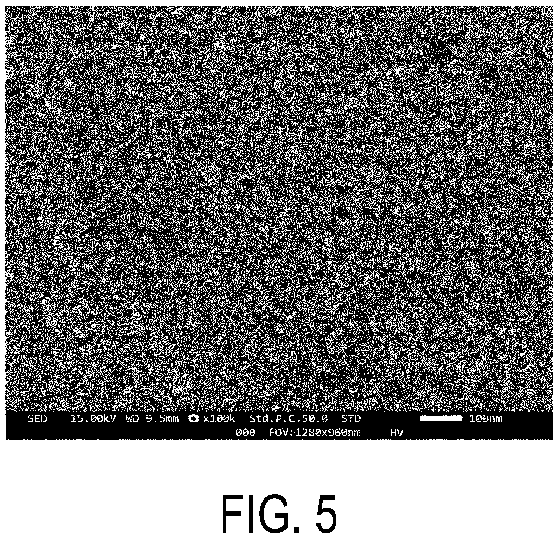

As illustrated in FIG. 3, the copper cake according to Example 3 had a large proportion of plate-shaped copper particles in a standing state, and thus the ratio $S_{Cu}$ (111)/$S_{Cu}$ (220) was a small value of less than 1.2. As illustrated in FIG. 4, the copper cake according to Example 5 had a large proportion of plate-shaped copper particles in a lying state, and thus the ratio $S_{Cu}$ (111)/$S_{Cu}$ (220) was a large value of more than 1.4. On the other hand, as illustrated in FIG. 5, the copper cake according to Comparative Example 1 had a large proportion of spherical copper particles, the ratio $S_{Cu}$ (111)/$S_{Cu}$ (220) was a value in the range of from 1.2 to 1.4.

REFERENCE SIGNS

10 Semiconductor device
20 Electrical component
1 Lead frame
2, 12 Cured product of paste composition
3 Semiconductor element
4 Electrode
5 Lead
6 Bonding wire
7 Cured product of sealing resin composition
11 Heat dissipating member
13 Heat generating member

**Claims**

1. A copper particle in which a ratio $S_{Cu}$ (111)/$S_{Cu}$ (220) of a crystallite diameter $S_{Cu}$ (111) at a Miller index (111) of copper to a crystallite diameter $S_{Cu}$ (220) at a Miller index (220) of copper in X-ray diffraction satisfies the following equation (1) or the following equation (2):

$$S_{Cu}\,(111)/S_{Cu}\,(220) > 1.4 \ldots (1)$$

$$S_{Cu}\,(111)/S_{Cu}\,(220) < 1.2 \ldots (2).$$

2. The copper particle according to claim 1, wherein the crystallite diameter $S_{Cu}$ (111) is not more than 60 nm.

3. The copper particle according to claim 1 or 2, having a thickness of from 5 to 50 nm and a major axis of from 30 to 300 nm.

4. The copper particle according to any one of claims 1 to 3, comprising: a core made of copper; and a shell made from at least one of an amine compound or a carboxylic acid.

5. The copper particle according to any one of claims 1 to 4, comprising: a core made of copper; and a shell made from a phosphoric acid derivative.

6.  A method for producing the copper particle according to any one of claims 1 to 5, the method comprising reducing, in the presence of a shape stabilizer, cuprous oxide having a crystallite diameter $S_{Cu2O}$ (111) at a Miller index (111) of not less than 70 nm in X-ray diffraction.

7.  The method for producing the copper particle according to claim 6, wherein the shape stabilizer is a neutralized salt of an alkanolamine having 4 or more carbon atoms and a fatty acid having 6 or more carbon atoms.

8.  A paste composition comprising the copper particle according to any one of claims 1 to 5.

9.  A semiconductor device formed by bonding using the paste composition according to claim 8.

10. An electrical component formed by bonding using the paste composition according to claim 8.

11. An electronic component formed by bonding using the paste composition according to claim 8.

FIG. 1

FIG. 2

FIG. 3

FIG. 4

SED    15.00kV WD 9.5mm ⚙ x100k  Std.P.C.50.0  STD              100nm
                          000  FOV:1280x960nm      HV

FIG. 5

## INTERNATIONAL SEARCH REPORT

| International application No. |
|---|
| **PCT/JP2023/013465** |

**A.   CLASSIFICATION OF SUBJECT MATTER**

*B22F 1/00*(2022.01)i; *B22F 1/054*(2022.01)i; *B22F 1/06*(2022.01)i; *B22F 1/07*(2022.01)i; *B22F 1/102*(2022.01)i;
*B22F 1/103*(2022.01)i; *B22F 1/16*(2022.01)i; *B22F 7/08*(2006.01)i; *B22F 9/00*(2006.01)i; *B22F 9/20*(2006.01)i;
*B82Y 30/00*(2011.01)i; *B82Y 40/00*(2011.01)i; *C22C 1/04*(2023.01)i; *C22C 32/00*(2006.01)i; *H01L 21/52*(2006.01)i
FI:  B22F1/00 L; B22F1/054; B22F1/06; B22F1/07; B22F1/102; B22F1/103; B22F1/16; B22F7/08 C; B22F9/00 B;
     B22F9/20 E; B82Y30/00; B82Y40/00; C22C1/04 A; C22C32/00 B; H01L21/52 E

According to International Patent Classification (IPC) or to both national classification and IPC

**B.   FIELDS SEARCHED**

Minimum documentation searched (classification system followed by classification symbols)

B22F1/00; B22F1/054; B22F1/06; B22F1/07; B22F1/102; B22F1/103; B22F1/16; B22F7/08; B22F9/00; B22F9/20;
B82Y30/00; B82Y40/00; C22C1/04; C22C32/00; H01L21/52

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| A | JP 2020-035979 A (KYOCERA CORP) 05 March 2020 (2020-03-05)<br>entire text | 1-11 |
| A | WO 2022/045252 A1 (NATIONAL UNIVERSITY CORPORATION HOKKAIDO UNIVERSITY) 03 March 2022 (2022-03-03)<br>entire text | 1-11 |
| A | JP 2020-029392 A (NATIONAL UNIVERSITY CORPORATION HOKKAIDO UNIVERSITY) 27 February 2020 (2020-02-27)<br>entire text | 1-11 |
| A | KR 10-2011-0008386 A (INDUSTRY-ACADEMIC COOPERATION FOUNDATION, DANKOOK UNIVERSITY) 27 January 2011 (2011-01-27)<br>entire text | 1-11 |

✓ Further documents are listed in the continuation of Box C.    ✓ See patent family annex.

| | |
|---|---|
| *      Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **09 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

# EP 4 501 496 A1

| INTERNATIONAL SEARCH REPORT | International application No. |
| --- | --- |
| | **PCT/JP2023/013465** |

**C. DOCUMENTS CONSIDERED TO BE RELEVANT**

| Category* | Citation of document, with indication, where appropriate, of the relevant passages | Relevant to claim No. |
| --- | --- | --- |
| A | JP 2020-084242 A (KYOCERA CORP) 04 June 2020 (2020-06-04)<br>entire text | 1-11 |
| A | JP 2016-196705 A (KYORITSU KAGAKU SANGYO) 24 November 2016 (2016-11-24)<br>entire text | 1-11 |

Form PCT/ISA/210 (second sheet) (January 2015)

23

INTERNATIONAL SEARCH REPORT
Information on patent family members

International application No.

**PCT/JP2023/013465**

| Patent document cited in search report | | | Publication date (day/month/year) | Patent family member(s) | | | Publication date (day/month/year) |
|---|---|---|---|---|---|---|---|
| JP | 2020-035979 | A | 05 March 2020 | WO | 2020/044982 | A1 | |
| | | | | TW | 202014259 | A | |
| WO | 2022/045252 | A1 | 03 March 2022 | CN | 115461173 | A | |
| JP | 2020-029392 | A | 27 February 2020 | (Family: none) | | | |
| KR | 10-2011-0008386 | A | 27 January 2011 | (Family: none) | | | |
| JP | 2020-084242 | A | 04 June 2020 | WO | 2020/105497 | A1 | |
| | | | | TW | 202026074 | A | |
| JP | 2016-196705 | A | 24 November 2016 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011240406 A

- JP 2014167145 A